# EUROPEAN PATENT SPECIFICATION

(11) **EP 0 348 018 B1**
(45) Date of publication and mention of the grant of the patent: **19.05.1999**
(21) Application number: 89202085.0
(22) Date of filing: 23.02.1983
(51) Int. Cl.: H01L 23/49, H01L 21/607

(54) **Method of manufacture of a resin encapsulated semiconductor device**
Verfahren zum Herstellen einer harzumhüllte Halbleiteranordnung
Procédé de fabrication d'un dispositif semi-conducteur encapsulé par une résine

(30) Priority: 10.03.1982 JP 36468/82
(43) Date of publication of application: 27.12.1989
(62) Divisional of application: 83300956.6
(73) Proprietor: HITACHI, LTD., Chiyoda-ku, Tokyo (JP)
(72) Inventor: Onuki, Jin, Hitachi-shi Ibaraki-ken (JP); Suwa, Masateru, Naka-gun Ibaraki-ken (JP); Koizumi, Masahiro, Hitachi-shi Ibaraki-ken (JP); Iizuka, Tomio, Naka-gun Ibaraki-ken (JP); Tamamura, Takeo, Hitachi-shi Ibaraki-ken (JP)
(74) Representative: Paget, Hugh Charles Edward

(56) References cited:
- EP-A- 0 043 692
- GB-A- 2 055 508
- US-A- 3 838 240
- US-A- 4 213 556
- PATENT ABSTRACTS OF JAPAN, vol. 6, no. 72 (E-105)[950], 7th May 1982; & JP-A-57 012 531 (FUJITSU)
- MANUFACTURING ENGINEERING AND TECHNOLOGY, pub. Addison-Wesley; S. Kalpakjian, p. 65
- FUNDAMENTALS OF ENGINEERING MATERIALS, pub. Prentice-Hall 1992; P. Thornton, pp. 162-163, 470-472
- DUCTILE FRACTURE AND DUCTILITY, pub. Academic Press 1987; B. Dodd and Y. Bai, Section 2.1.4 and 2.1.5
- AN INTRODUCTION TO METALLURGY, pub. Edward Arnold 1975; A. Cottrell, pp. 386-387

## Description

The present invention relates to a method of manufacturing a resin encapsulated semiconductor device.

In resin encapsulated semiconductor devices (such as an IC, LSI or transistor), Au wire of diameter of 20 - 50 µm is generally employed for the electrical connection between the semiconductor element and the external lead frame of the package. To bond the wire to the semiconductor element, there are two methods, wedge bonding and ball bonding. In these solid state bonding methods, one end of the Au wire, or a ball formed at the end of the Au wire through fusion thereof by means of a discharge or hydrogen flame, is bonded to the semiconductor element directly or through a deposited metallic film by thermocompression bonding or ultrasonic bonding. The connection at the other end of the wire to the lead frame is effected by wedge bonding using a capillary tube.

The use of Al wire instead of Au wire has been studied, since Au wire is expensive. For Al wire, wedge bonding by means of thermo-compression bonding or ultrasonic bonding has also been investigated. However, conventional Al wire, when used as it has been drawn, retains a hardness caused by the drawing. The present inventors have found that in both thermo-compression bonding and ultrasonic bonding of Al wire, the part of the wire near the bonded portion is softened by heating, so that a local deformation takes place at the bonding portions in the connection of the wire from the semiconductor element to the lead frame, and that such a local deformation not only causes the wire to be locally reduced but also may result in breakage or the like.

Moreover, the present inventors have discovered, as a result of examination of ball bonding of Al wire, that since conventional Al wire is wound on a reel as it has been drawn, the wire is elastically bent when a ball is formed at its end and the ball is eccentrically formed. Furthermore, since when the ball is formed not only the end but also the vicinity of the end is heated, the portion of the wire directly above the ball is partially subjected to annealing and, consequently becomes softened or locally constricted.

The inventors have also found that the eccentricity of the ball may cause the bonding portion to project from a pad, bringing about a short-circuit with another bonding portion or damage to the circuit.

Furthermore, the inventors have discovered that if a constriction is produced directly above the ball or if the wire softens, since the portion not annealed remains work-hardened, the residual work set of the wire prevents the wire and the bonding portion from occupying a fine curve, so that the wire is bonded in a bent shape, which may cause breakage of the wire, particularly in a dual in-line type IC or LSI having a difference in level between the bonding surfaces of the semiconductor element and the lead frame. This may cause a short-circuit between the wire and the semiconductor element.

In resin encapsulated semiconductor devices a larger mechanical stress is applied to the wire because it is rigidly molded with thermosetting resins such as epoxy resins, phenol resins, polyester resins, etc. The mechanical stress is maximum at the bonding position on the semiconductor chip. Thus, it has now been found that in resin encapsulated semiconductor devices the nature of the wire materials play a very important role in the production of a satisfactory ball bonding connection.

JP-A-57-12531 discloses improvement of the elongation of a fine Al wire used in a resin-coated semiconductor device, to avoid breakage during the coating with resin. The wire is heated to 150 to 400°C after bonding to the IC substrate.

EP-A-43692 disclose use of various metals, including Al and Cu, in ball-bonding.

It is an object of the invention to provide a method of manufacturing a resin encapsulated semiconductor device containing an electrical connection with a wire which permits good connections to be formed and with which there is a low risk of breakage of the wire.

The present invention is set out in claim 1. In the invention, an annealed Cu wire is used to connect the semiconductor element to the lead frame.

Devices of the prior art and embodiments of the present invention will now be described by way of example with reference to the accompanying drawings, in which:-
Fig. 1 is a sectional view of a semiconductor device with a wire having a wedge-bonded connection at both ends;
Fig. 2 is a sectional view of a semiconductor device with a wire having a ball-bonded connection at one end and a wedge-bonded connection at the other end;
Fig. 3(a) is a sectional view indicating a further step following Fig. 2 in wedge-bonding;
Fig. 3(b) is a sectional view showing how a ball is formed by discharge;
Fig. 4 is a sectional view of a resin molded type semiconductor device embodying the present invention; and
Fig. 5 is a bar graph showing the relationship between conventional wires and wires used in the present invention, on the one hand, and the percentage of production of eccentricity and the percentage of production of ecccentricity and constriction, on the other hand.

Since a wire made of a metal having in the annealed state an elongation at room temperature of not more than 60% is very highly work-hardened in the worked state (i.e. after the wire has been worked), it is difficult to destroy the oxide film formed on the surface of the ball in thermo-compression bonding or ultrasonic bonding, so that bonding is difficult. Moreover, since the vicinity of the bonding portion is softened by heating during bonding as described above, the local deformation is especially large. It has now been discovered that it is necessary to anneal the wire made of a metal having such an elongation so that it becomes softer. Annealing permits the wire to be softened throughout, so that there is no possibility of local deformation, and consequently, problems such as disconnection are solved.

It is preferable to employ a wire having a specific resistance at room temperature (20°C) of not more than 15 µΩcm.

The bonding process is a ball bonding procedure and can be effected by ultrasonic bonding or thermo-compression bonding. Ball bonding is preferable and generally more effective in the case of a semiconductor element which is a circuit element, because bonding distance is limited and the necessity to turn the semiconductor device is avoided. On the other hand, in the case of the external terminal at the lead frame, wedge bonding is preferable and can achieve high efficiency.

Figs. 1, 2 and 3(a) illustrate wedge-bonding. A wire 1 emerges from a capillary feeder 2, the bottom end of which is used to effect the wedge-bonding, as Figs. 1 and 2 show. After the bonding step, the capillary 2 is removed to break the wire, leaving a bonded portion 6 attached to the Cu lead frame 4. The lead frame may alternatively be a Fe-Ni alloy. Fig. 1 shows the other end of the wire 1 wedge-bonded to a metal layer on the top of the semiconductor element 3, which is itself mounted on another part of the lead frame 4.

Fig. 2 shows a ball-bonded connection of the wire 1 at the top surface of the semiconductor element 3. Fig. 3(b) shows how, in ball-bonding the ball 7 is formed using the surface tension of the wire itself by fusing the end of the wire held by a capillary 2 by means of discharge, hydrogen flame, plasma arc, a laser beam or the like. Particularly preferred, as illustrated in Fig. 3(b) is arc discharge between the wire itself and a separate electrode 5. The arc discharge is performed with the wire at minus polarity, whereby a clean ball having no oxide film on its surface is formed. In addition, it is possible to supply a pulse current of at least one of positive and negative in the arc discharge. The pulse current permits control of the correct arc-generating time necessary for formation of a ball. When supplying a current of positive and negative, control can be effected by converting the time required for cleaning and the time required for formation of a ball into a time ratio between positive and negative. The time required for cleaning accounts for just a small percentage of the discharge time (10 - 30% of the discharge time).

It is preferable that the heating-fusing atmosphere in the ball formation is a non-oxidising atmosphere. Particularly preferred is an inert gas including a small amount, preferably 5 - 15 vol.% of a reducing gas (e.g. hydrogen gas).

Fig. 3(b) shows how the ball 7 may be eccentrically formed.

Although any ball diameter is in principle useful, preferred are diameters 1.5 - 4 times, particularly 2.5 - 3.5 times, as large as the wire diameter.

A preferred wire diameter range in the invention is 20 - 100 µm, although this varies according to the kind of metal. For example, the Cu wire diameter may be about 30 µm. The wire diameter is selected in relation to the specific resistance.

The annealing temperature is higher than the recrystallizing temperature of the metal, although it differs according to the kind of metal. There is particularly employed a temperature at which the wire is substantially full-annealed to an extent such that it is not elastically deformed, i.e. contains substantially no elastic deformation. It is preferable that the wire is softened so as to have the same hardness throughout, since if the wire locally has a difference in hardness, a local deformation is produced, as described above. The preferred annealing temperatures are 400 - 600°C for Cu.

The wire, after being bonded to a circuit element, may be cut in the vicinity of the bonded portion of the circuit element by holding the wire in a capillary and pulling it (Fig. 3(a)). It may be difficult to cut the wire in the vicinity of the circuit element, since the wire itself is soft throughout, in which case it is preferable to cut the wire with a cutter.

Since the wire usually has an extremely small diameter and is soft as described above, in order to protect it, the semiconductor element, the wire and a part of the lead frame are covered with resin. Typically, liquid resin is case or molded and then hardened.

Fig. 4 is a sectional view of a resin-encapsulated type semiconductor device produced by a method according to the present invention. The wire 1 is ball-bonded to the semiconductor element 3 which is provided with an Al deposited film 8, and is wedge-bonded to the lead frame 4 which is provided with an Ag or Ni deposited layer 10. After the ball bonding, a protective film 13 such as SiO₂ or the like is provided on the layer 8. Then, a thermosetting resin composition 12 is transfer-molded to form the semiconductor device shown in Fig. 4. A low-melting glass 9 may be used to mount the semiconductor element 3.

Since in the present invention local deformation of the wire in ball bonding can be avoided and consequently a desired loop shape can be obtained, there is minimal possibility of disconnection due to local deformation and moreover, there is no risk of defect such as the short-circuit of the wire with the element.

The production of balls at Cu and, for comparison Al, wire ends for subsequent bonding will now be described.

A ball was formed by the method of Fig. 3(b) at the end of each of a Cu wire having a diameter of 30 µm and remaining as it has been worked and a wire obtained by subjecting such a wire to a full annealing of 1-hour heating at 400°C in Ar gas.

The discharge was effected under a voltage of 1000V, a current of 10 - 20 mA and in Ar gas. The discharge time was controlled by the speed of movement of the W electrode 5 and the pulse frequency, as described above.

In a similar manner to the above, a ball was formed at the end of each of an Al wire having a diameter of 50 µm and remaining as it has been worked and a wire obtained by subjecting such an Al wire to a full annealing of 1-hour heating at 250°C. The discharge conditions were substantially the same as for the Cu wires, except that the discharge current was 1 to 10 mA.

For each of these types of Cu and Al wires, 50 balls were formed, and the number of the balls having constrictions and eccentricity was examined and then the percentage thereof was obtained. The results are shown in Fig. 5.

Fig. 5 shows that the Al wire remaining as it has been worked exhibits a constriction level of 60% and eccentricity level of 50%, while the annealed Al wire exhibits a constriction level of only 7% and eccentricity level of the order of a few %. It forms a round ball symmetrical with respect to the wire axis. The Cu wire is better than the Al wire even when the Cu wire remains as it has been worked, the annealed Cu wire produced hardly any constriction and eccentricity.

Thus, by the present invention, it is possible to obtain a wire connection having no local deformation at the bonding portion of the wire.

## Claims

1. A method of manufacturing a resin encapsulated semiconductor device having at least one semiconductor element (3), the method including the steps of:
solid state bonding one end of a wire (1) to a semiconductor element (3) and the other end to a lead frame; and
encapsulating said element and wire hermetically with a resin (12), characterized in that said wire (1) is made of Cu and, before said bonding step, is fully annealed at a temperature higher than the recrystallization temperature of the metal material, subsequently having a maximum elongation at room temperature of not more than 60%, and in that said wire (1) is bonded to said semiconductor element by ball-bonding and to said lead frame by wedge-bonding,
the ball for the ball-bonding being formed on the wire after the annealing of the wire, the ball prior to the ball-bonding being round in shape, symmetrical with respect to the axis of the wire and having substantially no local construction at its tip adjacent to the ball.

2. A method according to claim 1, wherein at said one end the wire (1) is ball-bonded to an Al thin film formed on said semiconductor element while at said other end of said wire is wedge-bonded to an Ag, Ni or Al thin film formed on the surface of said lead frame which is made of a Cu or Fe-Ni alloy, and said semiconductor element, said wire and a part of said lead frame are enclosed within said molded resin.

3. A method according to claim 1 or 2, wherein said wire has a diameter in the range of 20 to 100 µm.

4. A method according to any one of claims 1 to 3, wherein in said resin encapsulated device said wire has a specific resistance at room temperature (20°C) of not more than 15 µΩcm.

## Patentansprüche

1. Verfahren zur Herstellung einer harzgekapselten Halbleiteranordnung mit mindestens einem Halbleiterelement (3), wobei
das eine Ende eines Drahtes (1) an das Halbleiterelement (3) und das andere Ende an einen Zuleitungsrahmen halbleitermäßig kontaktiert wird und
das Element und der Draht dicht mit einem Harz (12) eingekapselt werden,
dadurch gekennzeichnet, daß der Draht (1) aus Cu besteht und vor dem Kontaktieren bei einer Temperatur oberhalb der Rekristallisationstemperatur des Metalls vollständig geglüht wird, wodurch seine maximale Längendehnung bei Raumtemperatur höchstens 60% beträgt, und daß
der Draht (1) an das Halbleiterelement durch Nagelkopfbondierung und an den Zuleitungsrahmen durch Keilbondierung kontaktiert wird, wobei der Kopf für das Nagelkopfbondieren nach Glühen des Drahtes am Draht gebildet wird, dieser Kopf vor dem Nagelkopfbondieren von runder Form und symmetrisch zur Drahtachse ist, und daß der Draht im wesentlichen keine lokale Einschnürung an seiner zum Kopf benachbarten Spitze aufweist.

2. Verfahren nach Anspruch 1, dadurch gekennzeichnet, daß das eine Drahtende an eine dünne, auf dem Halbleiterelement gebildete Al-Schicht nagelkopfbondiert wird, während das andere Drahtende an eine dünne Ag, Ni oder Al-Schicht keilbondiert wird, wobei letztere Schicht auf der Oberfläche des aus Cu oder Fe-Ni-Legierung hergestellten Zuleitungsrahmen gebildet ist, und daß das Halbleiterelement, der Draht und ein Teil des Zuleitungsrahmens von dem Formharz eingeschlossen ist.

3. Verfahren nach Anspruch 1 oder 2, bei dem der Draht einen Durchmesser im Bereich von 20 bis 100 µm besitzt.

4. Verfahren nach einem der Ansprüche 1 bis 3, bei dem der Draht in der harzgekapselten Anordnung einen spezifischen Widerstand von höchstens 15 µΩcm bei Raumtemperatur (20°C) aufweist.

## Revendications

1. Procédé pour fabriquer un dispositif à semi-conducteur encapsulé dans de la résine comportant au moins un élément semi-conducteur (3), le procédé comportant les étapes consistant à :
fixer une première extrémité d'un fil (1) à un élément semi-conducteur (3) et fixer l'autre extrémité à une grille de connexion, et
encapsuler hermétiquement ledit élément et ledit fil dans de la résine (12), caractérisé en ce que ledit fil (1) est constitué de Cu et en ce que, avant ladite étape de fixation, le fil est complètement recuit à une température supérieure à la température de recristallisation du matériau métallique, le fil ayant après recuit un allongement maximal à température ambiante ne dépassant pas 60 %, et en ce que ledit fil (1) est fixé audit élément semi-conducteur par soudage par bille et est fixé à ladite grille de connexion par soudage en biseau, la bille pour le soudage par bille étant formée sur le fil après le recuit du fil, la bille, avant le soudage par bille, étant ronde en termes de forme, symétrique par rapport à l'axe du fil et n'ayant pratiquement aucune constriction locale à son extrémité adjacente à la bille.

2. Procédé selon la revendication 1, dans lequel, à ladite première extrémité, le fil (1) est fixé par soudage par bille à un film mince d'Al formé sur ledit élément semi-conducteur, tandis que, à ladite autre extrémité, ledit fil est fixé par soudage en biseau à un film mince d'Ag, de Ni ou d'Al formé sur la surface de ladite grille de connexion qui est constituée d'un alliage de Cu ou de Fe-Ni, et ledit élément semi-conducteur, ledit fil et une partie de ladite grille de connexion sont noyés dans ladite résine moulée.

3. Procédé selon la revendication 1 ou 2, dans lequel ledit fil a un diamètre dans la plage de 20 à 100 µm.

4. Procédé selon l'une quelconque des revendications 1 à 3, dans lequel, dans ledit dispositif encapsulé dans de la résine, ledit fil a une résistance spécifique, à température ambiante (20°C), qui n'est pas supérieure à 15 µΩcm.
